# FASCICULE DE BREVET EUROPEEN

(11) **EP 2 092 999 B1**
(45) Date de publication et mention de la délivrance du brevet: **05.09.2012**
(21) Numéro de dépôt: 09152308.4
(22) Date de dépôt: 06.02.2009
(51) Int. Cl.: B22D 25/02, B22D 27/04, B22C 9/20, C30B 11/04

(54) **Procédé de fabrication d'aubes à solidification dirigée**
Verfahren zur Herstellung von Laufradschaufeln mit gesteuertem Erstarrungsprozess
Method of manufacturing vanes with directional solidification

(30) Priorité: 08.02.2008 FR 0800680
(43) Date de publication de la demande: 26.08.2009
(73) Titulaire: SNECMA, 75015 Paris (FR)
(72) Inventeur: Fargeas, Serge, 75015, PARIS (FR)
(74) Mandataire: Gevers France

(56) Documents cités:
- EP-A- 1 207 004
- EP-A- 1 818 510
- EP-A- 1 894 647
- WO-A-00/25959
- FR-A- 2 724 857
- US-A- 4 804 311
- HANS J. HEINE, ERIC FORD: "Advances at Rolls-Royce in investment casting technology" FOUNDRY MANAGEMENT & TECHNOLOGY, vol. 5, 1988, pages 22-24, XP009100160

## Description

La présente invention concerne le domaine des aubes de turbomachine obtenues par coulée de métal dans un moule carapace et vise un procédé de fabrication des aubes avec solidification dirigée de type colonnaire ou monocristallin.

Le procédé de fabrication, désigné de fonderie à cire perdue, comprend une succession d'étapes rappelées ci-après. On réalise un modèle en cire ou autre matériau provisoire de la pièce à fabriquer. Le cas échéant les pièces sont réunies en une grappe autour d'un fût central également en cire. On forme une carapace en matériau céramique par trempages successifs dans des barbotines appropriées comprenant des particules de matières céramiques en suspension dans un liquide, alternés de saupoudrages de sable réfractaire. On élimine ensuite le modèle en cire et on consolide par chauffage le moule carapace ainsi formé. On coule l'alliage métallique en fusion dans le moule carapace et on refroidit le métal de manière à diriger la solidification de celui-ci selon la structure cristalline désirée.

Après solidification, on élimine la carapace par décochage. Enfin on procède aux étapes de finition.

L'étape de refroidissement et solidification comporte avantageusement une solidification dirigée, lorsqu'il est souhaitable de conférer aux pièces moulées des propriétés mécaniques et physiques particulières. C'est notamment le cas lorsque les pièces moulées sont des aubes de turbomachine.

La solidification du métal ou de l'alliage étant le passage de la phase liquide à la phase solide, la solidification dirigée consiste à faire progresser la croissance de "germes" dans un bain de métal fondu dans une direction donnée, en évitant l'apparition de germes nouveaux par le contrôle du gradient thermique et de la vitesse de solidification. La solidification dirigée peut être colonnaire ou monocristalline. La solidification dirigée colonnaire consiste à orienter tous les joints de grains dans la même direction, de telle manière qu'ils ne contribuent pas à la propagation de fissures. La solidification dirigée monocristalline, consiste à supprimer totalement les joints de grains.

On obtient la solidification dirigée, colonnaire ou monocristalline, de manière connue en soi en plaçant un moule carapace, ouvert en sa partie inférieure, sur une sole refroidie, en introduisant l'ensemble dans un équipement de chauffe capable de maintenir le moule céramique à la température du liquidus de l'alliage à mouler. Une fois la coulée effectuée, le métal situé dans des ouvertures ménagées au bas du moule carapace se solidifie quasi-instantanément au contact de la sole refroidie, et se fige sur une hauteur limitée de l'ordre du centimètre sur laquelle il présente une structure granulaire équi-axe, c'est-à-dire que sa solidification sur cette hauteur limitée s'effectue de façon naturelle, sans direction privilégiée. Au-dessus de cette hauteur limitée, le métal demeure à l'état liquide, du fait du chauffage extérieur imposé. On déplace la sole à vitesse contrôlée vers le bas de manière à extraire le moule céramique du dispositif de chauffage conduisant à un refroidissement progressif du métal qui continue à se solidifier depuis la partie basse du moule jusque vers sa partie haute.

La solidification dirigée colonnaire est obtenue en maintenant un gradient de température approprié en grandeur et en direction dans la zone de changement de phase liquide-solide, pendant cette opération de déplacement de la sole. Cela permet d'éviter une surfusion génératrice de nouveaux germes en avant du front de solidification. Ainsi, les seuls germes qui permettent la croissance des grains sont ceux qui préexistent dans la zone équi-axe solidifiée au contact de la sole refroidie. La structure colonnaire ainsi obtenue est constituée d'un ensemble de grains étroits et allongés.

La solidification dirigée monocristalline comprend en outre l'interposition entre la pièce à mouler et la sole refroidie, soit d'une chicane ou sélecteur de grain, soit d'un germe monocristallin ; on contrôle le gradient thermique et la vitesse de solidification de façon qu'il ne se crée pas de nouveaux germes en avant du front de solidification. Il en résulte une pièce moulée monocristalline après refroidissement.

Cette technique de solidification dirigée, qu'elle soit colonnaire ou monocristalline, est couramment utilisée pour réaliser des pièces moulées, et notamment des aubes de turbomachine.

De plus, de manière connue en soi lors de la mise en oeuvre d'un procédé de moulage à cire perdue, avec ou sans solidification dirigée, on utilise des masselottes, afin de supprimer les défauts de porosité dans des zones d'extrémité des pièces à fabriquer. En pratique, on prévoit des volumes excédentaires lors de la réalisation des modèles en cire, qui sont placés contre les zones des pièces qui sont susceptibles de présenter des défauts de porosité après solidification. Lors de la réalisation de la carapace, les volumes excédentaires se traduisent par des volumes supplémentaires à l'intérieur de la carapace, et se remplissent de métal en fusion lors de la coulée, de la même manière que les autres parties de la carapace. Les masselottes sont les réserves de métal solidifié qui remplissent les volumes supplémentaires dans la carapace. Les défauts de porosité, lorsqu'ils surviennent, sont alors déplacés dans les masselottes et ne sont plus localisés dans les pièces fabriquées elles-mêmes. Puis, une fois le métal solidifié et refroidi, les masselottes sont éliminées lors d'une opération de parachèvement des pièces, par exemple par usinage, par tronçonnage ou par meulage.

On connaît par ailleurs, tel que décrit dans le brevet FR 2724857 au nom de la demanderesse, un procédé de fabrication d'aubes monocristallines, telles que de distributeur de turbine, constituées d'au moins une pale entre deux plateformes transversales par rapport aux génératrices de la pale. Le procédé est du type selon lequel on alimente le moule en métal fondu à sa partie supérieure. On opère une solidification dirigée dont le front progresse verticalement de bas en haut, on sélectionne un grain de cristal unique au moyen d'un dispositif de sélection placé à la partie inférieure du moule et à la sortie duquel on se trouve en présence d'un grain unique d'orientation prédéterminée et de direction se confondant avec la verticale.

Selon ce procédé, on dispose les carapaces du moule de façon à ce que les plateformes soient orientées selon un plan parallèle à la direction [001] du monocristal sélectionné et à ce que les génératrices de la pale soient parallèles à l'une des directions horizontales [100] et [010] du monocristal sélectionné par le dispositif de sélection de grain, en ce qu'on fait déboucher la sortie du dispositif de sélection de grain entre les deux plateformes dans un raccordement reliant le dispositif de sélection aux extrémités inférieures des plateformes, et en ce qu'on alimente le moule en métal fondu au niveau des extrémités supérieures des plateformes. Les notions de verticalité et d'horizontalité sont relatives. On désigne par verticalité les directions coïncidentes de propagation du front de solidification et de croissance [001] du monocristal sélectionné par le dispositif de sélection. Le monocristal sélectionné par le dispositif de sélection a des directions horizontales [100] et [010].

Ce procédé permet d'obtenir des aubes entièrement monocristallines - pales et plateformes - et d'éliminer les porosités et les micro-retassures des plateformes.

Par ailleurs du fait des dimensions respectives d'une pale et des plateformes, on peut couler davantage d'aubes dans une même grappe quand on dispose les pièces dans la grappe, l'encombrement horizontal d'une pale ainsi disposée étant inférieur à celui d'une plateforme. Enfin cette disposition permet de placer très facilement le noyau destiné à réaliser une pale creuse, en l'encastrant dans les parois du moule, ce qui assure la tenue du noyau pendant la coulée.

Ce procédé présente cependant certains inconvénients. Actuellement on réalise le moule carapace de façon à ce que le bord d'attaque soit le long du bord inférieur du volume formant la pale, avec un conduit central entre les deux branches du conduit de raccordement entre le dispositif de sélection de grain et les plateformes. Le monograin initié au début de la solidification est ainsi séparé pour alimenter les deux plateformes et le conduit central. Il s'ensuit la présence de recollements de grains dans la pale. Ces recollements peuvent se traduire par un fort contraste de part et d'autre de ces zones donc par des faiblesses en résistance mécanique, on est alors amené à envoyer l'aubage présentant ces caractéristiques au rebut.

Par ailleurs, le conduit central rattaché au bord d'attaque doit être éliminé par usinage. Actuellement cette opération est effectuée manuellement à la bande abrasive. Il s'ensuit que le profil de l'aubage dans cette zone peut être modifié par l'opération. Dans certains cas cela peut conduire à des épaisseurs de paroi non conformes. La pièce doit alors être envoyée au rebut.

Il existe donc un besoin d'amélioration de ce type de procédé sur le plan de la qualité métallurgique de la pièce, la qualité du profil du bord d'attaque ainsi que de ses paramètres dimensionnels. Il serait aussi souhaitable de supprimer les opérations de retouche et de finition du bord d'attaque dans le but de réduire le coût de fabrication.

On parvient à réaliser ces objectifs conformément à l'invention, avec un procédé de fabrication d'aube monocristalline de distributeur de turbomachine comprenant une pale entre deux plateformes, par coulée de métal en fusion dans un moule carapace suivie d'une solidification dirigée dont le front progresse verticalement de bas en haut, depuis un monocristal fourni par un dispositif fournisseur de grain monocristallin placé à la partie inférieure du moule et d'orientation prédéterminée, la direction [001] se confondant avec la verticale, les volumes du moule formant les plateformes étant orientés selon un plan parallèle à la direction [001] dudit monocristal, et le volume du moule formant la pale comprenant un bord inférieur, le dispositif fournissant le grain débouchant dans un conduit de grain formant raccordement entre ledit dispositif et les extrémités inférieures des plateformes, le conduit de grain étant conformé de façon à comprendre deux branches d'alimentation des plateformes et un volume en forme de voile s'étendant entre lesdites deux branches, les plateformes et le bord inférieur de la pale, caractérisé par le fait que le bord supérieur du volume formant la pale est incliné par rapport à la direction horizontale, d'un angle compris entre 8 et 14°.

Par cette configuration le grain n'est pas séparé lors de sa croissance ; il n'y a pas de recollement de grains donc pas de risques de mise au rebut pour cette raison.

Selon un mode préféré, le bord inférieur du volume du moule formant la pale est le bord de fuite de la pale. Dans ce cas le voile est éliminé lors de l'opération d'usinage par découpe fil du bord de fuite. Il n'y a pas de supplément de coût par rapport à la solution antérieure. Le surplus de métal faisant office de masselotte est éliminé.

L'angle de 8 à 14° évite une perte de charge du métal liquide trop importante. On conserve donc des teneurs de porosité au dessous des critères d'acceptation. Le bord d'attaque est ainsi obtenu de fonderie et ne nécessite plus de retouche mécanique manuelle. En outre l'absence d'usinage permet d'obtenir un profil d'aube au bord d'attaque et des épaisseurs de parois reproductibles.

L'absence d'usinage permet de réduire les coûts de fabrication.

Selon un autre mode de réalisation possible, le bord inférieur du volume formant la pale est le bord d'attaque de la pale.

Le dispositif fournissant le grain monocristallin est un germe monocristallin ou bien un dispositif de sélection de grain.

Conformément à un autre aspect de l'invention ledit bord inférieur du volume du moule formant la pale est parallèle à l'une des directions principales horizontales [010] ou [100] du monocristal fourni par ledit dispositif fournisseur de grain monocristallin.

On décrit maintenant l'invention correspondant à un mode de mise en oeuvre du procédé non limitatif, en référence aux dessins annexés sur lesquels,
La figure 1 montre schématiquement, vu de côté, un modèle en cire d'une aube de distributeur avant réalisation du moule carapace, selon l'art antérieur.
La figure 2 montre schématiquement un modèle en cire d'une aube de distributeur de turbomachine conforme à l'invention et avant réalisation d'un moule carapace.
La figure 3 représente une grappe de modèles en cire pour la formation de plusieurs aubes de distributeurs.

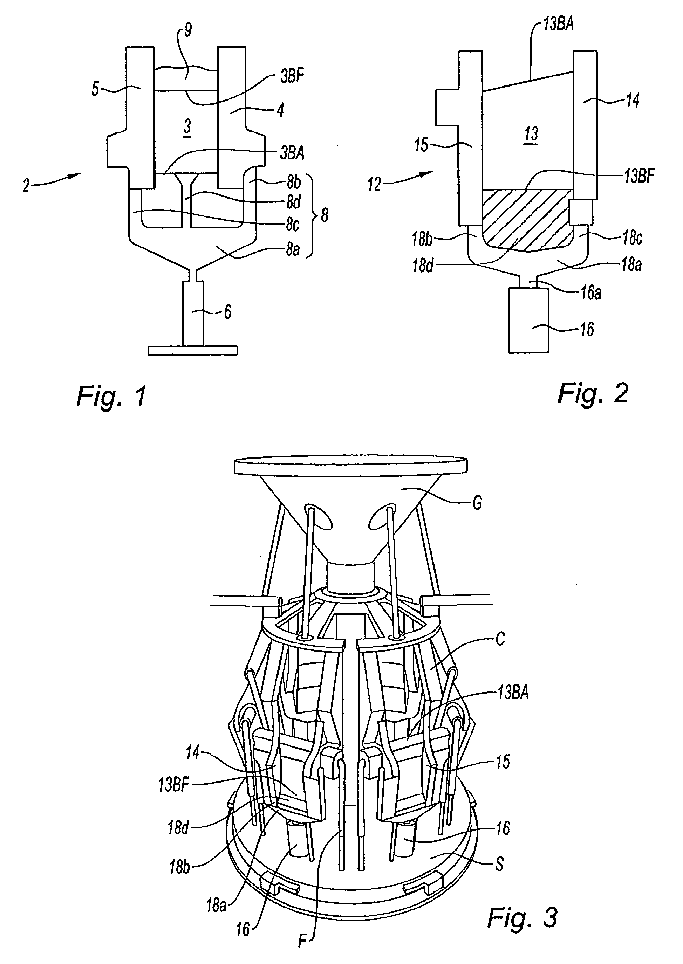

En se reportant à la figure 1, le type de modèle, en cire ou autre matériau provisoire, utilisé pour la fabrication d'aubages selon l'art antérieur comprend une partie formant l'aube 2. Celle-ci se compose d'une pale 3, orientée dans le plan de la figure. Aux extrémités de celle-ci et orientées transversalement par rapport au plan de la figure sont rattachées deux plateformes verticales, 4 et 5 respectivement. Les plateformes comprennent des moyens de fixation au carter de la turbomachine et définissent l'une la paroi intérieure de la veine de gaz l'autre sa paroi extérieure. L'aube est disposée dans le modèle de façon que le bord de fuite 3BF de la pale soit le bord supérieur et le bord d'attaque 3BA soit le bord inférieur. Ce dernier est horizontal. On a ménagé également une masselotte 9 le long du bord de fuite supérieur 3BF.

La partie inférieure du modèle comprend le modèle de germe monocristallin 6 qui est en forme de cylindre vertical avec un méplat axial d'orientation du grain autour de l'axe vertical, non visible sur la figure. Le modèle de germe 6 se prolonge verticalement par un conduit de grain 8. Entre les deux, le modèle est en forme de cylindre 6a de plus faible diamètre que le cylindre 6.

Le conduit de grain comprend une partie 8a de forme ici triangulaire avec un sommet du triangle sur le cylindre 6a et le côté du triangle opposé à ce sommet, horizontal. Les deux autres sommets sont prolongés chacun par une branche, 8b et 8c, verticale et cylindrique qui est raccordée à la base des plateformes verticales 4 et 5. Un conduit central, cylindrique et vertical, 8d relie la partie triangulaire 8a au bord d'attaque 3BA de la pale.

Pour la réalisation de la coulée, ce modèle est assemblé avec quelques autres, identiques, autour d'un fût en une grappe communiquant avec un godet d'alimentation. Le moule carapace est construit autour de cet assemblage par des trempages successifs dans des barbotines de particules céramiques alternés avec des applications de poudre céramiques. Après consolidation du moule carapace et élimination du modèle, on dispose un germe dans la cavité inférieure du moule. Le grain est orienté avec la direction [001] verticale et l'une des directions [010] ou [100] parallèle à la pale. On coule le métal en fusion par le godet. Le métal s'écoule de haut en bas jusqu'au germe qui fond en partie. Pendant l'étape de solidification dirigée le monocristal se forme à partir du germe. La restriction 6a permet d'éliminer les grains parasites. Ensuite le cristal se forme progressivement et le front de solidification se propage également le long des conduits 8b, 8c et 8d puis dans l'aube jusqu'au sommet des plateformes. La masselotte en 9 garantit que les porosités éventuelles ne se forment pas dans la pale mais la masselotte elle-même. On constate cependant parfois la formation de deux zones de recollement de grains dans la pale parallèlement aux plateformes entre celles-ci et le conduit central 8d.

On évite l'apparition de tels défauts avec la solution de l'invention.

On a représenté sur la figure 2, un modèle, en cire ou autre matériau provisoire, agencé conformément à l'invention.

Le modèle 10 comprend une partie formant l'aube 12 avec une pale 13 et deux plateformes 14 et 15. Comme dans l'art antérieur les plateformes sont verticales, (dans la position de la coulée du métal en fusion). A la différence de l'art antérieur toutefois la pale est inversée : le bord d'attaque 13BA de la pale 13 du modèle est du côté supérieur et le bord de fuite 13BF est du côté inférieur, tourné vers la base de la grappe.

La partie inférieure du modèle comprend un modèle de germe 16 avec une partie rétrécie 16a comme dans le modèle de l'art antérieur. Celle-ci se prolonge par un conduit de grain 18 qui comprend un élément de raccordement transversal 18a et deux branches verticales 18b, 18c de part et d'autre de l'élément de raccordement transversal 18a qui sont reliées chacune à la base d'une plateforme verticale 14 et 15 respectivement. A la différence de l'art antérieur, un voile 18d comble l'espace entre l'élément de raccordement transversal 18a, les deux branches verticales 18b, 18c et le bord de fuite 13BF. Ce voile a une épaisseur plus faible que les conduits de grain verticaux.

Il est à noter que la partie formant l'aube est disposée par rapport aux conduits de grains de telle façon que le bord de fuite 13BF soit perpendiculaire à la direction [001] du germe constituant l'axe de solidification. Ainsi le bord d'attaque 13BA opposé est-il légèrement incliné par rapport à cette même direction, de 8 à 14° correspondants à la forme de l'aube.

Pour la fabrication des pièces, on assemble une pluralité de modèles ainsi réalisés en une grappe telle que celle représentée sur la figure 3. Les modèles 10 reposent sur un socle S en étant soutenus par des tiges T. Les modèles 16 de germe en appui sur ce dernier. Les éléments C en cire, destinés à former les canaux d'alimentation sont disposés sur les parties supérieures des plateformes 14 et 15, disposées verticalement, et relient ces dernières à un godet G en élévation par rapport à celles-ci.

On forme le moule carapace autour de cet assemblage. On élimine les modèles en cire, on dispose les germes en les orientant convenablement avec la direction [001] verticalement et une direction [010] ou [001] parallèlement au bord de fuite.

Le moule carapace comprend des volumes correspondants exactement au modèle en cire. On emploie les mêmes références pour désigner à la fois les parties du modèle, les différents volumes ou parties du moule carapace et les parties de la pièce métallique coulée dans le moule.

Après coulée du métal en fusion, un superalliage à base nickel par exemple, on procède à la solidification dirigée de façon connue en soi. Le front de solidification se propage verticalement selon la direction [001] du germe et le cas échéant selon l'une des directions [010] ou [100] parallèlement à une génératrice de la pale. L'inclinaison du bord d'attaque 13BA évite les pertes de charge dans le métal liquide dans cette zone et l'apparition de porosité.

En résumé la solution de l'invention permet
- la suppression de l'opération de parachèvement au niveau du conduit central de grain et au niveau de la retouche du profil du bord d'attaque,
- la suppression du défaut de recollement de grains,
- la suppression des grains recristallisés au niveau du conduit central avec respect du profil et de l'épaisseur de paroi du bord d'attaque obtenu de fonderie.

Au lieu d'un germe on peut utiliser un dispositif de sélection de grain tel qu'un dispositif à chicane avec une succession de passages rectilignes disposés dans un même plan vertical perpendiculairement les uns aux autres, le dernier débouchant dans le raccordement.

De façon plus particulière, le dispositif comprend au moins un passage vertical et un passage horizontal, de sorte qu'on est assuré d'être en présence, à la sortie de la chicane, d'un monocristal correctement orienté : son axe [001] est vertical, et une autre direction [010] ou [100] est horizontale et dans le plan de la chicane.

L'élément de raccordement peut être de forme variée, notamment en forme de T, Y, V, en prisme, en barrette, ou en triangle plein.

## Revendications

1. Procédé de fabrication d'aube monocristalline de distributeur de turbomachine comprenant une pale (13) entre deux plateformes (14), par coulée de métal en fusion dans un moule carapace suivie d'une solidification dirigée dont le front progresse verticalement de bas en haut, depuis un monocristal fourni par un dispositif (16) fournisseur de grain monocristallin placé à la partie inférieure du moule et d'orientation prédéterminée, la direction [001] se confondant avec la verticale, les volumes du moule formant les plateformes (14) étant orientés selon un plan parallèle à la direction [001] dudit monocristal et le volume du moule formant la pale comprenant un bord inférieur, le dispositif fournissant le grain monocristallin débouchant dans un conduit de grain (18) formant raccordement entre ledit dispositif et les extrémités inférieures des plateformes, le conduit de grain (18) étant conformé de façon à comprendre deux branches d'alimentation (18b, 18c) des plateformes (14) et un volume en forme de voile (18d) s'étendant entre lesdites branches d'alimentation (18b, 18c), les plateformes (14) et le bord inférieur (13BF), de la pale (13), **caractérisé par le fait que** le bord supérieur (13BA) du volume formant la pale est incliné par rapport à la direction horizontale, d'un angle compris entre 8 et 14°.

2. Procédé selon la revendication 1 dont le bord inférieur du volume formant la pale est le bord de fuite (13BF) de la pale.

3. Procédé selon la revendication 1 dont le bord inférieur du volume formant la pale est le bord d'attaque de la pale.

4. Procédé selon l'une des revendications 1 à 3 dont le dispositif (16), fournissant le grain monocristallin, est un germe monocristallin.

5. Procédé selon l'une des revendications 1 à 3 dont le dispositif fournissant le grain monocristallin est un dispositif de sélection de grain.

6. Procédé selon la revendication 2 ou 3 dont ledit bord inférieur du volume formant la pale est parallèle à l'une des directions principales horizontales [010] ou [100] du monocristal fourni par ledit dispositif fournisseur de grain monocristallin.

## Claims

1. A process for manufacturing a single-crystal turbomachine nozzle guide vane comprising an airfoil (13) between two platforms (14), by pouring molten metal into a shell mold followed by directional solidification, the front of which advances vertically upward, from a single crystal provided by a single-crystal grain provider device (16) placed in the lower portion of the mold and having a predetermined orientation, the [001] direction coinciding with the vertical, the volumes of the mold forming the platforms (14) being oriented in a plane parallel to the [001] direction of said single crystal and the volume of the mold forming the airfoil comprising a lower edge, the device providing the single-crystal grain emerging in a grain duct (18) forming a connection between said device and the lower ends of the platforms, the grain duct (18) being shaped so as to comprise two branches (18b, 18c) for feeding the platforms (14) and a web-shaped volume (18d) extending between said feed branches (18b, 18c), the platforms (14) and the lower edge (13BF) of the airfoil (13), wherein the upper edge (13BA) of the volume forming the airfoil is inclined to the horizontal direction at angle of between 8° and 14°.

2. The process as claimed in claim 1, wherein the lower edge of the volume forming the airfoil is the trailing edge of the airfoil.

3. The process as claimed in claim 1, wherein the lower edge of the volume forming the airfoil is the leading edge of the airfoil.

4. The process as claimed in one of the preceding claims 1 to 3, wherein the device (16) providing the single-crystal grain is a single-crystal seed.

5. The process as claimed in one of claims 1 to 3, wherein the device providing the single-crystal grain is a grain selection device.

6. The process as claimed in claim 2 or 3, wherein said lower edge of the volume forming the airfoil is parallel to one of the horizontal main directions [010] or [100] of the single crystal provided by said single-crystal grain provider device.

## Patentansprüche

1. Verfahren zur Herstellung einer Einkristall-Turbinenschaufel eines Turbotriebwerkverteilers umfassend ein Schaufelblatt (13) zwischen zwei Plattformen (14), durch Flüssigmetallguss in einer Schalenform, gefolgt von einer gerichteten Erstarrung, deren Front senkrecht von unten nach oben aus einem Einkristall verläuft, der aus einer Einkristallkornvorrichtung (16) stammt, die mit einer vorbestimmten Ausrichtung in den unteren Abschnitt der Form platziert wird, wobei die Richtung [001] mit der Senkrechten übereinstimmt, die Volumina der Form, die die Plattformen (14) bilden, entsprechend einer zur Richtung [001] des besagten Einkristalls parallelen Ebene verlaufen, und das Volumen der Form, aus der das Schaufelblatt gebildet wird, eine untere Kante umfasst, und die Einkristallkornvorrichtung in einen Kornkanal (18) mündet, der den Anschluss zwischen der besagten Vorrichtung und den unteren Enden der Plattformen bildet, und der Kornkanal (18) so angepasst ist, dass er zwei Zuführungsäste (18b, 18c) zu den Plattformen (14) und ein Volumen in Segelform (18d) umfasst, das sich zwischen den besagten Zuführungsästen (18b, 18c), den Plattformen (14) und der unteren Kante (13BF) des Schaufelblattes (13) erstreckt, durch die Tatsache gekennzeichnet, dass die obere Kante (13BA) des Volumens, das das Schaufelblatt (13) bildet, in Bezug auf die waagrechte Richtung in einem Winkel geneigt ist, der zwischen 8 und 14° liegt.

2. Verfahren nach Anspruch 1, bei dem die untere Kante des Volumens, das das Schaufelblatt bildet, die Austrittskante des Schaufelblattes (13BF) ist.

3. Verfahren nach Anspruch 1, bei dem die untere Kante des Volumens, das das Schaufelblatt bildet, die Anströmkante des Schaufelblattes ist.

4. Verfahren nach einem der Ansprüche 1 bis 3, bei dem die Einkristallkornvorrichtung (16) ein Einkristallkeim ist.

5. Verfahren nach einem der Ansprüche 1 bis 3, bei dem die Einkristallkornvorrichtung eine Kornauswahlvorrichtung ist.

6. Verfahren nach Anspruch 2 oder 3, bei dem die besagte untere Kante des Volumens, das das Schaufelblatt bildet, parallel zu einer der waagrechten Hauptrichtungen [010] oder [100] des Einkristalls liegt, der von der besagten Einkristallkornvorrichtung beigestellt wird.
